# EUROPEAN PATENT APPLICATION

(11) **EP 2 586 810 A1**
(43) Date of publication of application: **01.05.2013**
(21) Application number: 10853445.4
(22) Date of filing: 25.06.2010
(51) Int. Cl.: C08G 61/12, H01L 51/00

(54) **CONJUGATED POLYMER BASED ON BENZODITHIOPHENE AND THIENOPYRAZINE, PREPARATION METHOD AND USES THEREOF**

(71) Applicant: Ocean's King Lighting Science&Technology Co., Ltd., Guangdong 518052 (CN)
(72) Inventor: ZHOU, Mingjie, Shenzhen Guangdong 518054 (CN); HUANG, Jie, Shenzhen Guangdong 518054 (CN); XU, Erjian, Shenzhen Guangdong 518054 (CN)
(74) Representative: Michalski Hüttermann & Partner Patentanwälte
(86) International application number: PCT/CN2010/074454
(87) International publication number: WO 2011/160302

(57) **Abstract**

A conjugated polymer based on benzodithiophene and thienopyrazine with the following formula is provided, 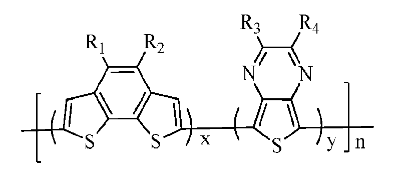 Wherein x+y=2, 0<y≤1, n represents an integer between 1 and 100; R₁, R₂ represent C₁ to C₂₀ alkyl; R₃, R₄ represent H, C₁ to C₂₀ alkyl, C₁ to C₂₀ alkoxy or C₁ to C₂₀ aryl. The conjugated polymer have high mobility of the carriers and excellent electrochemical reduction properties, high photoelectric conversion efficiency and a broad prospect of application in the field of photoelectric, especially in the field of polymer solar cells, organic electroluminescent device, organic field-effect transistor, organic optical storage, organic nonlinear material, organic laser materials, and so on. Method for the conjugated polymer preparation is provided too.

## Description

### FIELD OF THE INVENTION

The present disclosure relates to photoelectricity technology, and more particularly relates to conjugated polymer based on benzodithiophene and thienopyrazine, preparation method thereof and application thereof.

### BACKGROUND OF THE INVENTION

The preparation of low-cost and high-energy solar cells by using cheap materials has been a research hotspot and difficulty in the photovoltaic field. The application of the traditional silicon solar cells for terrestrial is limited due to the production process is complicated and high cost. In order to reduce the costs and expand the application scope, for a long time, people have been looking for novel solar cell materials.

Polymer solar cells have some advantages, such as low cost of materials, light weight, flexibility, preparation process easy and the polymer can be prepared in large areas by use of coating, printing, and so on, have attracted much attentions, if the energy conversion efficiency of the polymer solar cells can be enhanced to close to the level of the energy conversion efficiency of the commodity silicon solar cell, the market prospect of the polymer solar cells would be very wide. Since N. S. Sariciftci ect. (N. S Sariciftci, L. Smilowitz, A. J. Heeger, et al. Science, 1992, 258, 1474) reported that the photoinduced electron transfer phenomenon had been happened between the conjugated polymer and C60 in SCIENCE. People have made a lot of studies in the field of polymer solar cells, and achieved rapid development.

The researchers of the traditional polymer solar cells mainly focus on donor and acceptor blend system, an energy conversion efficiency of 7.4% has been achieved by PTB7 and PC71BM blend system (Y Liang et al., Adv. Mater.; DOI: 10.1002/adma.200903528), however, the conversion efficiency is still much lower than that of the inorganic solar cells. The factors that limit the development of performance are shown as follows: the carriers mobility of the organic semiconductor device is relatively low, the spectral response of the solar cells and the solar radiation spectrum doesn't match, the high photon flux of the red area is not utilized effectively, the efficiency of carriers collection on the electrode is low, and so on. In order to improve practical application of the polymer solar cells, the development of new materials and substantial increase in the energy conversion efficiency are still be the primary task in the research field.

### SUMMARY OF THE INVENTION

In one aspect of the present disclosure, a conjugated polymer based on benzodithiophene and thienopyrazinethienopyrazine with high photoelectric conversion efficiency is desired.

In addition, in another aspect of the present disclosure, a preparation method of the conjugated polymer based on benzodithiophene and thienopyrazinethienopyrazine with high photoelectric conversion efficiency is also desired and the application of conjugated polymer in photoelectricity technology is disclosed.

A conjugated polymer based on benzodithiophene and thienopyrazine has the following formula: 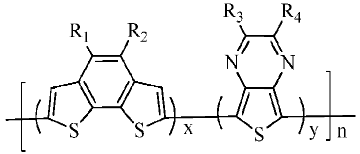 wherein x+y=2, 0<y≤1, n represents an integer between 1 and 100; R₁, R₂ represent C₁ to C₂₀ alkyl; R₃, R₄ represent H, C₁ to C₂₀ alkyl, C₁ to C₂₀ alkoxy or C₁ to C₂₀ aryl.

Preferably, the C₁ to C₂₀ aryl is selected from the group consisting of: 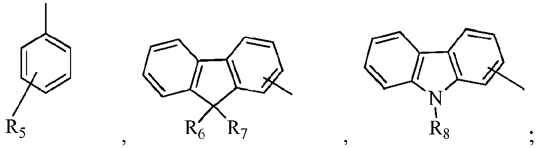 wherein R₅ represents C₁ to C₁₅ alkyl or C₁ to C₁₅ alkoxy, R₆, R₇, R₈ represent C₁ to C₁₅ alkyl.

A preparation method of the conjugated polymer based on benzodithiophene and thienopyrazine, includes:
S11, compounds A, B and C represented by the following formulas are provided, respectively, 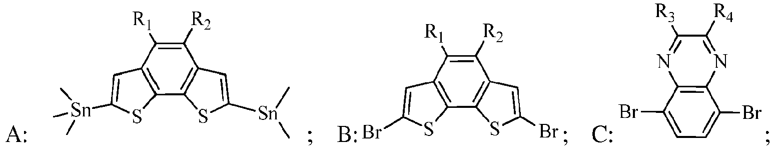
S12, under conditions of anhydrous and oxygen-free environment, compounds A, B and C are mixed and subjected to a Stille coupling reaction in the presence of catalyst and organic solvent according to the following reaction equation: 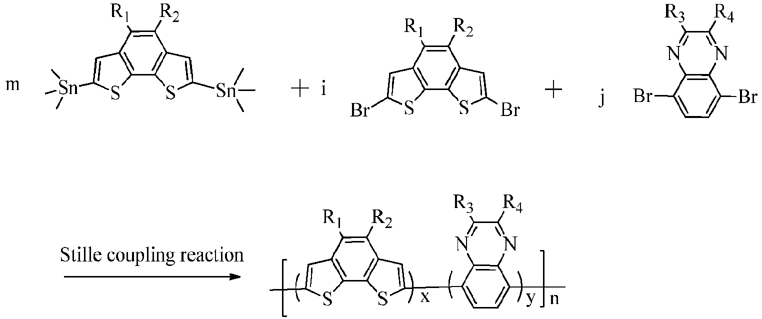 wherein m=i+j, 0≤i<m; the conjugated polymer represented by the following formula is obtained: 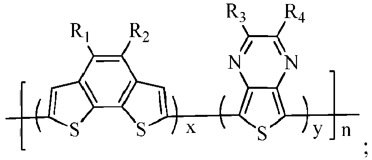 wherein x+y=2, 0<y≤1, n represents an integer between 1 and 100;
R₁, R₂ represent C₁ to C₂₀ alkyl;
R₃, R₄ represent H, C₁ to C₂₀ alkyl, C₁ to C₂₀ alkoxy or C₁ to C₂₀ aryl.

The C₁ to C₂₀ aryl described above is selected from the group consisting of: 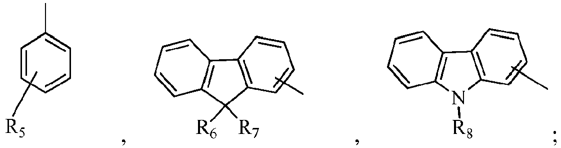 wherein R₅ represents C₁ to C₁₅ alkyl or C₁ to C₁₅ alkoxy, R₆, R₇, R₈ represent C₁ to C₁₅ alkyl.

Preferably, in step S11, compound C is prepared by the following steps:
compounds D and E represented by the following formulas are provided, respectively, 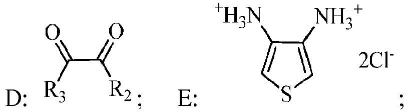 under a temperature of 0 to 78 □, the compound D and E according to a molar ratio of 1:0.1 to 1:10 are mixed and dissolved in solvent, the weak base is added according to a molar ratio of the weak base to the compounds of 2:1 to 50:1, after the reaction lasted for 1 to 24 hours, the compound F represented by the following formula is obtained: 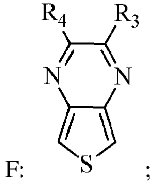 wherein the described solvent is at least one selected from methanol, ethanol and ethyl acetate; wherein the described weak base is one or two selected from triethylamine and sodium carbonate.
   under a temperature of 0 to 70°C, the compound F is added to a mixture solution of chloroform and acetic acid, and then added the n-bromosuccinimide, after the reaction lasted for 1 to 48 hours, the compound C represented by the following formula is obtained:

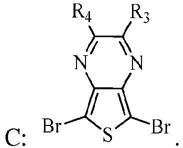

Preferably, in step S 12, the organic solvent is selected at least one from tetrahydrofuran, ethylene glycol, dimethyl ether, benzene, chlorobenzene and toluene; the reaction temperature is 60 to 130°C, the reaction time is 24 to 72 hours; the added amount of catalyst is 0.05% to 50% of a molar amount of compound A; the catalyst is organic palladium catalyst or a mixture of organic palladium and organic phosphine ligand; the molar ratio of the organic palladium to the organic phosphine ligand is 1:2 to 1:20 in the mixture of organic palladium and organic phosphine ligand; the organic palladium is Pd₂(dba)₃, Pd(PPh₃)₄ or Pd(PPh₃)₂Cl₂; the organic phosphine ligand is P(o-Tol)₃; the molar ratio of the organic palladium to the organic phosphine ligand is 1:2 to 1:20 in the mixture of organic palladium and organic phosphine ligand.

In a preferably embodiment, the preparation method of the conjugated polymer further includes the purification process after the conjugated polymer is obtained, the purification steps comprise:
S13, the conjugated polymer is added to the methanol, deposited, pumping filtrated, washed with methanol, dried, and a colloid containing conjugated polymer is obtained;
S14, the colloid containing conjugated polymer is dissolved in toluene, and then the toluene solution is added to the aqueous solution of sodium diethyl dithiocarbamate, after stirred and heated to 80 to 100□, the conjugated polymer is separated by alumina column chromatography, after the product is washed with chlorobenzene, the organic solvent is removed under reduced pressure;
S15, repeat step S13 at least once, the conjugated polymer separated from step S14 is extracted by acetone Soxhlet to obtain conjugated polymer solid.

A solar cell device using conjugated polymer described above includes a substrate, a conductive layer deposited on one surface of the substrate serving as an anodic, a polyethylene 3, 4 - ethylenedioxy thiophene: polystyrene sulfonic acid layer coated on the conductive layer for modification; an active layer coated on the surface of the polyethylene 3, 4 - ethylenedioxy thiophene: polystyrene sulfonic acid layer, and an aluminum layer coated on the active layer serving as a cathode; the material of the active layer is mixture, and the mixture includes electron donor materials and electron acceptor materials; the electron acceptor material is [6,6]-phenyl-C61-butyric acid methyl ester, the electron donor material includes conjugated polymer based on benzodithiophene and thienopyrazine described above.

An organic light-emitting device using conjugated polymer described above includes a substrate, a conductive layer deposited on one surface of the substrate serving as a anodic, a luminescent layer coated on the conductive layer, a buffer layer deposited on the surface of the luminescent layer, and an aluminum layer coated on the buffer layer serving as a cathode, the buffer layer is deposited by vacuum evaporation and the material of the buffer layer is LiF, the material of the luminescent layer includes the conjugated polymer based on benzodithiophene and thienopyrazine described above.

An organic field-effect transistor using conjugated polymer described above includes a doping silicon wafer, a SiO₂ insulation layer, an octadecyltrichlorosilane layer for modifying the SiO₂ insulation layer, an organic semiconductor layer coated on the octadecyltrichlorosilane layer, a source electrode and a drain electrode interval disposed on the described organic semiconductor layer, which are laminated in this order, the material of the organic semiconductor layer includes the conjugated polymer based on benzodithiophene and thienopyrazine described above.

The benzodithiophene has a rigid crystal structure------ two thiophene rings of its structural unit are within the same plane. This kind of structure can effectively enhance the conjugated performance of the polymer and reduce the bandwidth of the polymer. In addition, this kind of co-planar structure can make the carriers transfer between the two main chain easier and enhance the mobility of the carriers.

Thienopyrazine is acceptor unit, which has excellent planar structure and a five-membered ring and six-membered ring skeleton, in addition, the thieno-yrazine has intramolecular charge transfer properties and excellent electrochemical reduction properties.

The conjugated polymer based on benzodithiophene and thienopyrazine collects the advantages of the two units and has high mobility of carriers, excellent electrochemical reduction properties and high photoelectric conversion efficiency.

### BRIEF DESCRIPTION OF THE DRAWINGS

FIG. 1 is a schematic view of a solar cell device according to an embodiment;

FIG. 2 is a schematic view of an organic electroluminescent device according to an embodiment;

FIG. 3 a schematic view of an organic field-effect transistor according to an embodiment.

### DETAILED DESCRIPTION

The objective of the present invention is to provide a conjugated polymer based on benzodithiophene and thienopyrazine and its preparation method, and to disclose the application of the conjugated polymers materials in the photoelectric field.

A conjugated polymer based on benzodithiophene and thienopyrazine has the following formula: 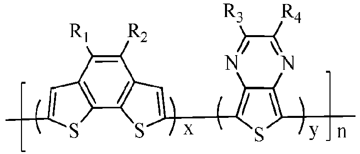 wherein x+y=2, 0<y≤1, n represents an integer between 1 and 100; R₁, R₂ represent C₁ to C₂₀ alkyl; R₃, R₄ represent H, C₁ to C₂₀ alkyl, C₁ to C₂₀ alkoxy or one of the construction units as follows: 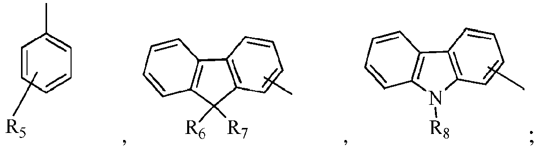 wherein R₅ represents C₁ to C₁₅ alkyl or C₁ to C₁₅ alkoxy, R₆, R₇, R₈ represent C₁ to C₁₅ alkyl.

A preparation method of conjugated polymer based on benzodithiophene and thienopyrazine includes the following steps:

Step one

Compounds D and E represented by the following formulas are provided, respectively, 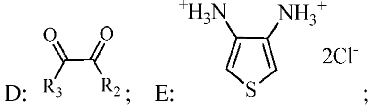 under a temperature of 0 to 78□, the compounds D and E according to a molar ratio of 1:0.1 to 1:10 are mixed and dissolved in solvent, the weak base is added according to a molar ratio of the weak base to the compounds of 2:1 to 50:1, after the reaction lasted for 1 to 24 hours, the compound F represented by the following formula is obtained: 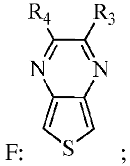 wherein the solvent is at least one selected from methanol, ethanol and ethyl acetate; wherein the weak base is one or two selected from triethylamine and sodium carbonate;
under a temperature of 0 to 70 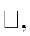 the compound F is added to a mixture solution of chloroform and acetic acid, and then added the n-bromosuccinimide, after the reaction lasted for 1 to 48 hours, the compound C represented by the following formula is obtained:

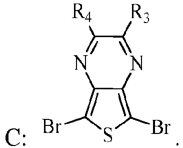

Step two

Compounds A, B and C represented by the following formula are provided, respectively, 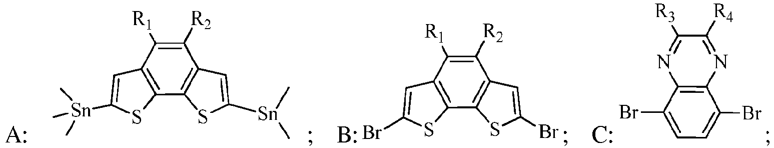 under conditions of anhydrous and oxygen-free environment, compounds A, B and C are mixed and subjected to a Stille coupling reaction in the presence of catalyst and organic solvent according to the following reaction equation: 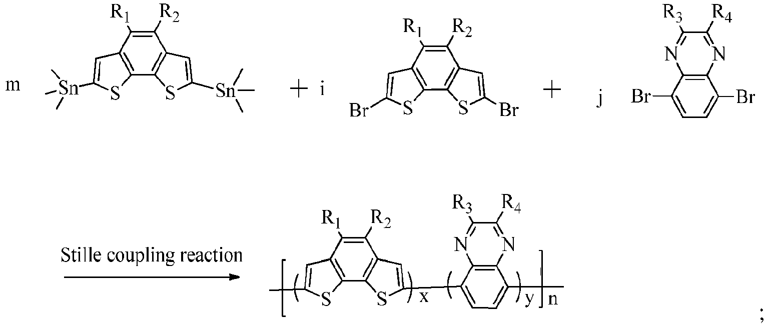 wherein m=i+j, 0≤i<m; the conjugated polymer represented by the following formula is obtained: 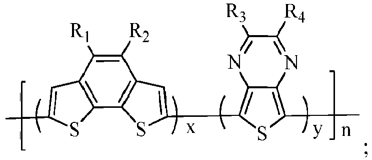 wherein x+y=2, 0<y≤1, n represents an integer between 1 and 100;
R₁, R₂ represent C₁ to C₂₀ alkyl;
R₃, R₄ represent H, C₁ to C₂₀ alkyl, C₁ to C₂₀ alkoxy or C₁ to C₂₀ aryl.

The C₁ to C₂₀ aryl described above is selected from the group consisting of: 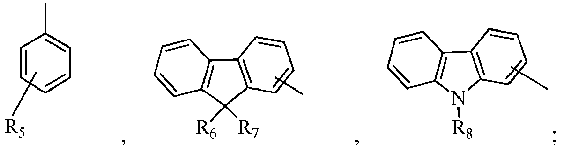 wherein R₅ represents C₁ to C₁₅ alkyl or C₁ to C₁₅ alkoxy, R₆, R₇, R₈ represent C₁ to C₁₅ alkyl,
the organic solvent is at least one selected from the group consisting of tetrahydrofuran, ethylene glycol, dimethyl ether, benzene, chlorobenzene and toluene; the reaction temperature is 60 to 130□, the reaction time is 24 to 72 hours; the added amount of catalyst is 0.05% to 50% of a molar amount of compound A; the catalyst is organic palladium catalyst or a mixture of organic palladium and organic phosphine ligand; a molar ratio of the organic palladium to the organic phosphine ligand is 1:2 to 1:20 in the mixture of organic palladium and organic phosphine ligand; organic palladium is Pd₂(dba)₃, Pd(PPh₃)₄ or Pd(PPh₃)₂Cl₂; organic phosphine ligand is P(o-Tol)₃; a molar ratio of the organic palladium to the organic phosphine ligand is 1:2 to 1:20 in the mixture of organic palladium and organic phosphine ligand.

Step three

A, the obtained conjugated polymer described above is added to the methanol, deposited, pumping filtrated, washed with methanol, dried, and a colloid containing conjugated polymer P obtained;
B, the colloid containing conjugated polymer is dissolved in toluene, and then the toluene solution is added to the aqueous solution of sodium diethyl dithiocarbamate, after stirred and heated to 80 to 100□, the conjugated polymer P is separated by alumina column chromatography, after the product is washed with chlorobenzene, the organic solvent is removed under reduced pressure;
C, repeat step A at least once, the conjugated polymer separated is extracted by acetone Soxhlet to obtain conjugated polymer solid.

The following specific embodiments are provided for further illustrate of the conjugated polymer, the preparation method of the conjugated polymer and its applications of the present invention disclosed.

Example 1

The 4, 5 - di - alkyl benzo[2,1-b:3,4-b']dithiophene - 2, 3 - bisphenyl thieno [3,4-b] pyrazine conjugated polymer is disclosed representing by the following formula:

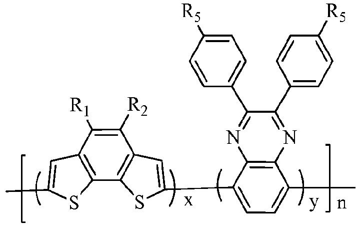

The preparation process of the polymer described above is as follows: firstly, the preparation of the compounds with the following formulas.

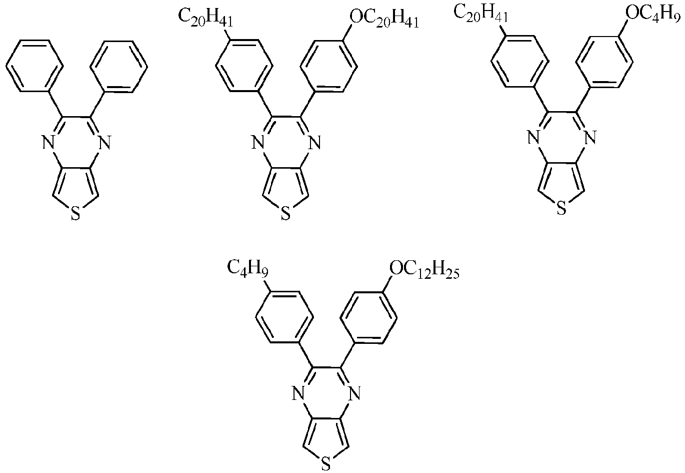

The preparation of 2, 3 - bisphenyl - thieno [3,4-b] pyrazine is taken as an example to illustrate, the preparation process is as follows: 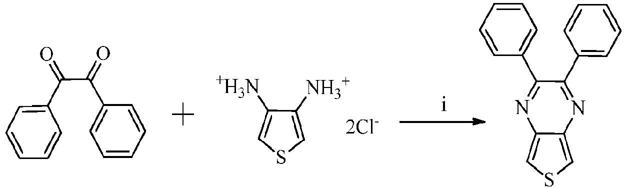 3, 4 - diamino - thiophene · hydrogen chloride (1.0g, 5.34mmol) was added to the anhydrous ethanol (100mL) solution of benzil (1.12g, 5.34mmol), the triethylamine (1.15g, 11mmol) was added to the solution under the dark condition and stirred overnight. After the solvent was removed by rotary evaporation, 1.1g of needle-like solid was separated by column chromatography (dichloromethane as eluent), the yield of the product was 69%. MS (EI) m/z: 288.4(M⁺).

Secondly, the preparation of the compounds with the following formulas

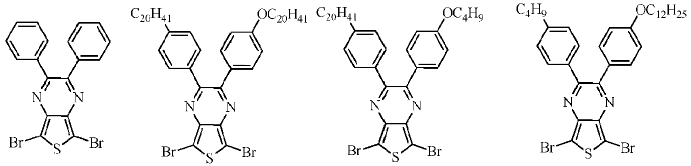

The preparation of 5, 7 - dibromo - 2, 3 - bisphenyl - thieno [3,4-b] pyrazine is taken as an example to illustrate, the preparation process is as follows:
NBS (0.72g, 4mmol) was added to the chloroform/acetic acid (V/V = 1/1, 10mL) solution which contained 2,3 - bisphenyl - thieno [3, 4-b] pyrazine compound (0.49g, 1.7mmol) and stirred overnight. The reaction solution was added to saturated sodium carbonate solution, extracted with chloroform, washed with water, and then dried over anhydrous sodium sulfate, after the solvent was removed by rotary evaporation, 0.42 of solid was separated by column chromatography, the yield of the product was 55%. MS (EI) m/z: 446 (M+).

Thirdly, the preparation of the compounds with the following formulas 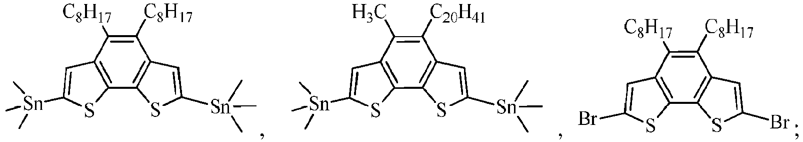 The corresponding product was obtained according to the method disclosed in Macromolecules 2008, 41, 5688. The preparation of 2, 7 - bis trimethyltin - 4, 5 - dioctyl benzo[2,1-b:3,4-b'] dithiophene is taken as an example to illustrate, the preparation process is as follows: 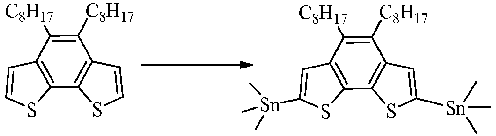 At -78°C, t - BuLi (5.3mL, 1.4mol/L, 7.5mmol) was added dropwise to tetrahydrofuran (100mL) solution of 4, 5 - dioctylfluorene benzo[2,1-b:3,4-b'] dithiophene (1.03g, 2.5) to obtain mixture solution, after the mixture solution was slowly recovered to the room temperature, the mixture solution was stirred for 0.5h, and then cooled to -78□ again, trimethyltin chloride (7.5mmol, 7.5mL) was added dropwise to the solution described above. The solution was recovered to the room temperature slowly and stirred overnight. The reaction liquid described above was quenched with water, rotary evaporated to remove tetrahydrofuran, extracted by chloroform/water, dried by anhydrous sodium after washed with water. 1.1g of brown solid was obtained after the organic phase was removed, the yield of the product was 54%. MS (MALDI) m/z: 617(M+).

Forthly, the preparation of conjugated polymer based on benzodithiophene and thienopyrazine

The preparation of P₁ (4, 5 - dioctyl benzo[2,1-b:3,4-b']dithiophene - 2, 3 - bisphenyl thieno [3,4-b] pyrazine conjugated polymer)

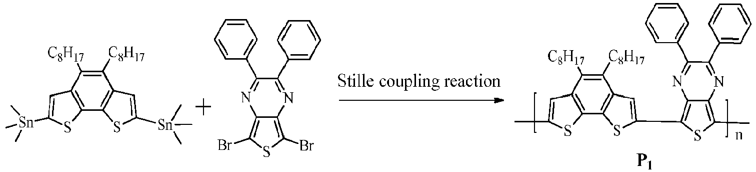

Under a nitrogen atmosphere, the chlorobenzene solution (20mL) containing 5, 7 - dibromo - 2, 3 - bisphenyl - thieno [3,4-b] pyrazine (0.22g, 0.5mmol) and 2,7 - bistrimethyltin - 4, 5 - dioctyl benzo[2,1-b:3,4-b']dithiophene (0.37g, 0.5mmol) was bubbled for 0.5 hours to remove the residual oxygen. Pd₂(dba)₃ (0.014g, 0.015mol) and P(o-Tol)₃ (0.0083g, 0.027mmol) were added to the solution, and then the solution was bubbled for 1 hour to remove the residual oxygen. The solution was heated and refluxed for 3 days to obtain the conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 90□ and the conjugated polymer was separated by alumina column chromatography, after the conjugated polymer was rinsed by chlorobenzenem, the organic solvent was removed under reduced pressure. The obtained conjugated polymer was added to methanol, deposited, pumping filtrated, washed with methanol and dried, the conjugated polymer was extracted by acetone Soxhlet to obtain 0.23g conjugated polymer solid, the yield of the product was 66%. Molecular weight (GPC, THF, R. I): Mₙ = 43,500, M_{w}/Mₙ = 2.1.

The preparation of P₂ (4, 5 - dioctyl benzo[2,1-b:3,4-b']dithiophene - 2, 3 - bisphenyl thieno [3,4-b] pyrazine conjugated polymer)

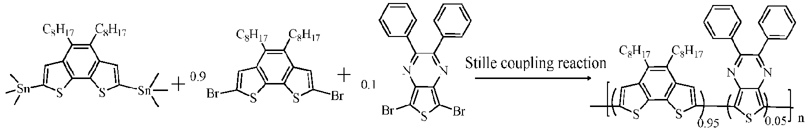

Under a nitrogen atmosphere, the chlorobenzene solution (20mL) containing 5, 7 - dibromo - 2, 3 - bisphenyl - thieno [3,4-b] pyrazine (0.022g, 0.05mmol), 2, 7 - dibromo - 4, 5 - dioctylfluorene benzo[2,1-b:3,4-b']dithiophene (0.26g, 0.45mmol) and 2, 7 - bistrimethyltin - 4, 5 - dioctyl benzo[2,1-b:3,4-b']dithiophene (0.37g, 0.5mmol) was bubbled for 0.5 hours to remove the residual oxygen. Pd₂(dba)₃ (0.014g, 0.015mol) and P(o-Tol)₃ (0.0083g, 0.027mmol) were added to the solution, and then the solution was bubbled for 1 hour to remove the residual oxygen. The solution was heated to 60□ and refluxed for 72 hours to obtain the conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 90□ and the conjugated polymer was separated by alumina column chromatography, after the conjugated polymer was rinsed by chlorobenzene, the organic solvent was removed under reduced pressure. The obtained conjugated polymer was added to methanol, deposited, pumping filtrated, washed with methanol and dried, the conjugated polymer was extracted by acetone Soxhlet to obtain 0.21g conjugated polymer solid, the yield of the product was 51%. Molecular weight (GPC, THF, R. I): Mₙ = 62,000, M_{w}/Mₙ = 1.9.

The preparation of P₃ (4 - methyl, 5 - n - dodecyl benzo[2,1-b:3,4-b']dithiophene - 2, 3 - bisphenyl thieno [3,4-b] pyrazine conjugated polymer)

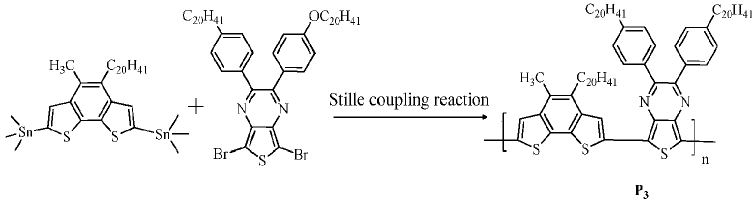

Under a nitrogen atmosphere, the chlorobenzene solution (20mL) containing 5, 7 - dibromo - 2 - (4 - n - eicosyl-phenyl)- 3 - (4 - n - twenty alkoxy-phenyl) thieno [3,4-b] pyrazine(0.51g, 0.5mmol) and 2,7 - bistrimethyltin - 4 - methyl, 5 - n - eicosyl benzo[2,1-b:3,4-b']dithiophene (0.41g, 0.5mmol) was bubbled for 0.5 hours to remove the residual oxygen. Pd₂(dba)₃ (0. 014 g, 0.015 mol) and P(o-Tol)₃ (0.0083 g, 0.027mmol) were added to the solution, and then the solution was bubbled for 1hour to remove the residual oxygen. The solution was heated to 60□ and refluxed for 72 hours to obtain the conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 90□, and then the conjugated polymer was separated by alumina column chromatography, after the conjugated polymer was rinsed by chlorobenzenem, the organic solvent was removed under reduced pressure. The obtained conjugated polymer was added to methanol, deposited, pumping filtrated, washed with methanol and dried, the conjugated polymer was extracted by acetone Soxhlet to obtain 0.43g conjugated polymer solid, the yield of the product was 64%. Molecular weight (GPC, THF, R. I): Mₙ = 82,000, M_{w}/Mₙ = 2.1.

The preparation of P₄ (4, 5 - dioctyl benzo[2,1-b:3,4-b']dithiophene - 2, 3 - bisphenyl thieno [3,4-b] pyrazine conjugated polymer)

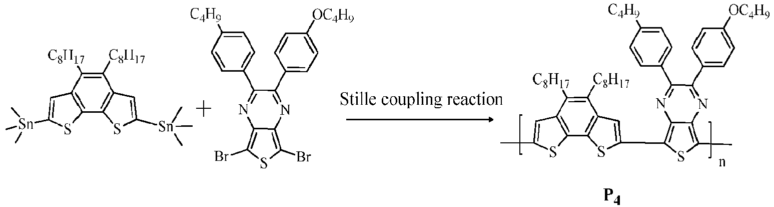

Under a nitrogen atmosphere, the chlorobenzene solution (20mL) containing 5, 7 - dibromo - 2 - (4 - n - butyl - phenyl) 3 - (4 - n - butoxy - phenyl) - thieno [3,4-b] pyrazine (0.29g, 0.5mmol) and 2, 7 - bistrimethyltin - 4, 5 - dioctyl benzo[2,1-b:3,4-b']dithiophene (0.37g, 0.5mmol) was bubbled for 0.5 hours to remove the residual oxygen. Pd₂(dba)₃ (0.014g, 0.015mol) and P(o-Tol)₃ (0.0083g, 0.027mmol) were added to the solution, and then the solution was bubbled for 1 hour to remove the residual oxygen. The solution was heated to 60□ and refluxed for 72 hours to obtain conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 90□, and then the conjugated polymer was separated by alumina column chromatography, after the conjugated polymer was rinsed by chlorobenzenem, the organic solvent was removed under reduced pressure. The obtained conjugated polymer was added to methanol, deposited, pumping filtrated, washed with methanol and dried, the conjugated polymer was extracted by acetone Soxhlet to obtain 0.26g conjugated polymer solid, the yield of the product was 61%. Molecular weight (GPC, THF, R. I): Mₙ = 37,400, M_{w}/Mₙ = 1.7.

Example 2

The 4, 5 - di - octyl benzo[2,1-b:3,4-b']dithiophene - 2 - phenyl - 3 - carbazolyl thieno [3,4-b] pyrazine conjugated polymer is disclosed representing by the following formula:

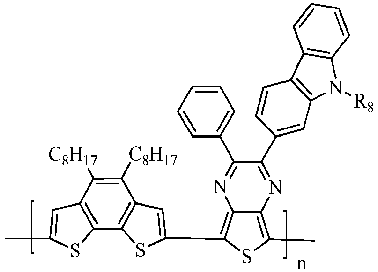

The preparation process of the polymer described above is as follows: firstly, the preparation of the compounds with the following formulas

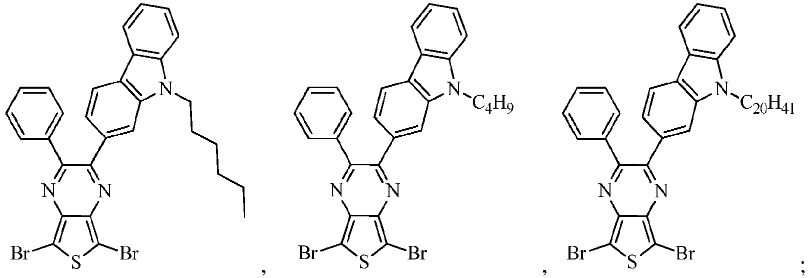

The preparation of 5, 7 - dibromo - 2 - (3 - (nitrogen hexyl carbazole) yl) - 3 - phenyl - thieno [3,4-b] pyrazine is taken as an example to illustrate, the preparation process is as follows: 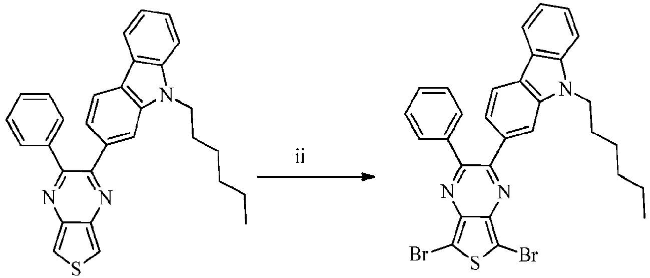 NBS (0.43g, 2.4mmol) was added to the chloroform/acetic acid (V/V = 1/1, 20mL) solution which contained 2 - (3 - (nitrogen hexyl carbazole) yl) - 3 - phenyl - thieno [3,4-b] pyrazine compound (0.50g, 1.1mmol) and stirred overnight. The reaction solution was added to saturated sodium carbonate solution, extracted with chloroform, washed with water, and then dried over anhydrous sodium sulfate. After the solvent was removed by rotary evaporation, 0.55g of solid was obtained through column chromatography, the yield of the product was 81%. MS (MALDI) m/z: 619 (M⁺).

Secondly, the preparation of conjugated polymer based on benzodithiophene and thienopyrazine.

The preparation of P₅ (4, 5 - dioctyl benzo[2,1-b:3,4-b']dithiophene - 2 - (3 - nitrogen alkyl carbazole) yl) - 3 - phenyl - thieno [3,4-b] pyrazine conjugated polymer).

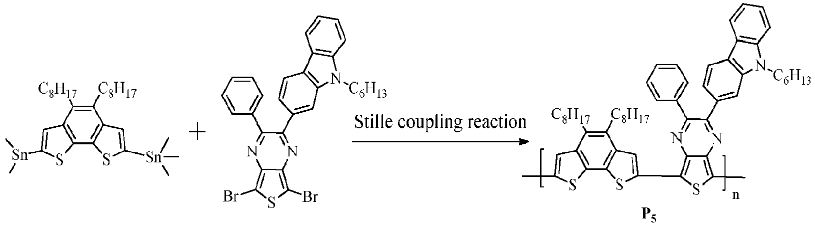

Under a nitrogen atmosphere, the chlorobenzene solution (20mL) containing 5, 7 - dibromo - 2 - (3 - (nitrogen hexyl carbazole) yl) - 3 - phenyl - thieno [3,4-b] pyrazine (0.31g, 0.5mmol) and 2, 7 - bistrimethyltin -4, 5 - dioctyl benzo[2,1-b:3,4-b']dithiophene (0.37g, 0.5mmol) was bubbled for 0.5 hours to remove the residual oxygen. Pd₂(dba)₃ (0.014g, 0.015mol) and P(o-Tol)₃ (0.0083g, 0.027mmol) were added to the solution, and then the solution was bubbled for 1 hour to remove the residual oxygen. The solution was heated to 80 and refluxed for 24 hours to obtain the conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 80⊏ and the conjugated polymer was separated by alumina column chromatography, after the conjugated polymer was rinsed by chlorobenzenem, the organic solvent was removed under reduced pressure. The obtained conjugated polymer was added to methanol, deposited, pumping filtrated, washed with methanol and dried, the conjugated polymer was extracted by acetone Soxhlet to obtain 0.29g conjugated polymer solid, the yield of the product was 66%. Molecular weight (GPC, THF, R. I): Mₙ = 37,000, M_{w}/Mₙ = 2.3.

The preparation of P₆ (4, 5 - dioctyl benzo[2,1-b:3,4-b']dithiophene - 2 - (3 - nitrogen alkyl carbazole) yl) - 3 - phenyl - thieno [3,4-b] pyrazine conjugated polymer).

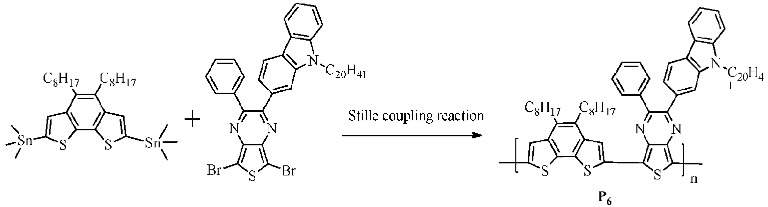

Under a nitrogen atmosphere, the chlorobenzene solution (20mL) containing 5, 7 - dibromo - 2 - (3 - n - eicosyl carbazole) yl) - 3 - phenyl- thieno [3,4-b] pyrazine (0.41g, 0.5mmol) and 2, 7 - bistrimethyltin - 4, 5 - dioctyl benzo[2,1-b:3,4-b']dithiophene (0.37g, 0.5mmol) was bubbled for 0.5 hours to remove the residual oxygen. Pd₂(dba)₃ (0. 014 g, 0.015 mol) and P(o-Tol)₃ (0.0083 g, 0.027 mmol) were added to the solution, and then the solution was bubbled for 1hour to remove the residual oxygen. The solution was heated to 80□ and refluxed for 24 hours to obtain the conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 80°C, and then the conjugated polymer was separated by alumina column chromatography, after the conjugated polymer was rinsed by chlorobenzenem, the organic solvent was removed under reduced pressure. The obtained conjugated polymer was added to methanol, deposited, pumping filtrated, washed with methanol and dried, the conjugated polymer was extracted by acetone Soxhlet to obtain 0.33g conjugated polymer solid, the yield of the product was 62%. Molecular weight (GPC, THF, R. I): Mₙ = 23,000, M_{w}/Mₙ = 2.1.

The preparation of P₇ (4, 5 - dioctyl benzo[2,1-b:3,4-b']dithiophene - 2 - (3 - nitrogen alkyl carbazole) yl) - 3 - phenyl - thieno [3,4-b] pyrazine conjugated polymer).

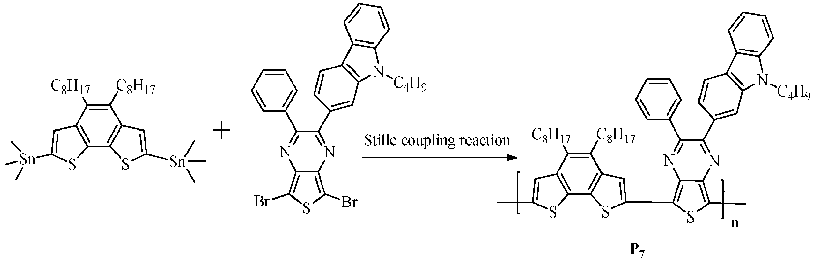

Under a nitrogen atmosphere, the chlorobenzene solution (20mL) containing 5, 7 - dibromo - 2 - (3 - (nitrogen n-butyl carbazole) yl) - 3 - phenyl - thieno [3,4-b] pyrazine (0.29g, 0.5mmol) and 2, 7 - bistrimethyltin - 4, 5 - dioctyl benzo[2,1-b:3,4-b']dithiophene (0.37g, 0.5mmol) was bubbled for 0.5 hours to remove the residual oxygen. Pd₂(dba)₃ (0.014g, 0.015mol) and P(o-Tol)₃ (0.0083g, 0.027mmol) were added to the solution, and then the solution was bubbled for 1 hour to remove the residual oxygen. The solution was heated to 80 and refluxed for 24 hours to obtain the conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 80⊏ and the conjugated polymer was separated by alumina column chromatography, after the conjugated polymer was rinsed by chlorobenzenem, the organic solvent was removed under reduced pressure. The obtained conjugated polymer was added to methanol, deposited, pumping filtrated, washed with methanol and dried, the conjugated polymer was extracted by acetone Soxhlet to obtain 0.17g conjugated polymer solid, the yield of the product was 48%. Molecular weight (GPC, THF, R. I): Mₙ = 17, 000, M_{w}/Mₙ = 2.1.

Example 3

The 4,5 - di-octyl benzo[2,1-b:3,4-b']dithiophene - 2, 3 - bis ((2 - (9, 9 - di - substituted fluorene) yl) thieno [3,4-b] pyrazine conjugated polymer is disclosed representing by the following formula:

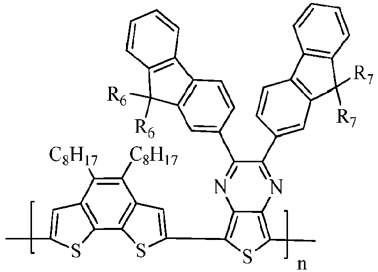

The preparation process of the polymer described above is as follows: firstly, the preparation of the compounds with the following formulas

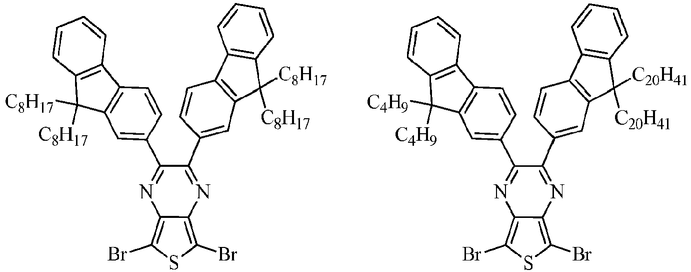

The preparation of 5, 7 - dibromo - 2, 3 - bis ((2 - (9, 9 - dioctyl fluorene) yl) thieno [3,4-b] pyrazine is taken as an example to illustrate, the preparation process is as follows: 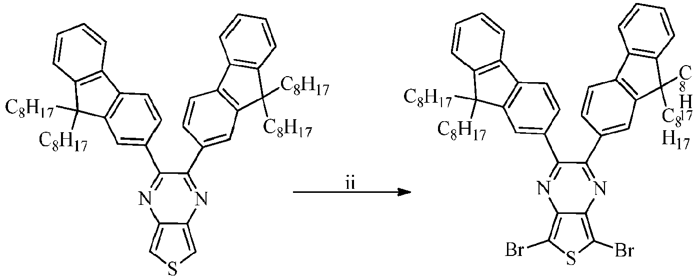 NBS (0.25g , 1.4mmol) was added to the chloroform/acetic acid (V/V = 1/1, 20mL) solution which contained 2 - (3 - (nitrogen hexyl carbazole) yl) - 3 - phenyl - thieno [3,4-b] pyrazine compound (0.55g, 0.6mmol) and stirred overnight. The reaction solution was added to saturated sodium carbonate solution, extracted with chloroform, washed with water, and then dried over anhydrous sodium sulfate. After the solvent was removed by rotary evaporation, 0.43g of solid was obtained through column chromatography, the yield of the product was 66%. MS (MALI) m/z: 1071 (M⁺).

Secondly, the preparation of conjugated polymer based on benzodithiophene and thienopyrazine

The preparation of P₈ (4, 5 - dioctyl benzo[2,1-b:3,4-b']dithiophene - 2, 3 - bis (2 - (9, 9 - dialkyl fluorene) yl) thieno [3,4-b] pyrazine conjugated polymer:

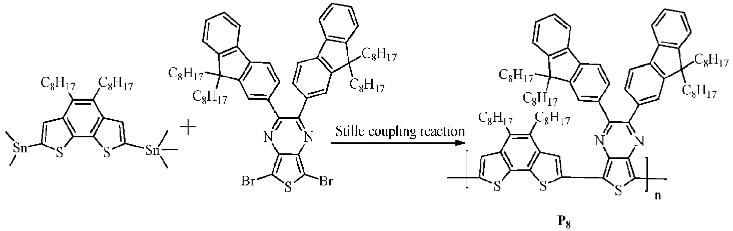

Under a nitrogen atmosphere, the toluene solution (30mL) containing 5, 7 - dibromo - 2, 3 - bis (2 - (9, 9 - dioctyl fluorene) yl) thieno [3,4-b] pyrazine (0.54g, 0.5mmol) and 2, 7 - bistrimethyltin - 4, 5 - dioctyl benzo[2,1-b:3,4-b']dithiophene (0.31g, 0.5mmol) was bubbled for 0.5 hours to remove the residual oxygen. Pd₂(dba)₃ (0.014g, 0.015mol) and P(o-Tol)₃ (0.0083g, 0.027mmol) were added to the solution, and then the solution was bubbled for 1 hour to remove the residual oxygen. The solution was heated to 130 and refluxed for 48 hours to obtain the conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 100□ and the conjugated polymer was separated by alumina column chromatography, after the conjugated polymer was rinsed by chlorobenzenem, the organic solvent was removed under reduced pressure. The obtained conjugated polymer was added to methanol, deposited, pumping filtrated, washed with methanol and dried, the conjugated polymer was extracted by acetone Soxhlet to obtain 0.41g conjugated polymer solid, the yield of the product was 62%. Molecular weight (GPC, THF, R. I): Mₙ = 92,500, M_{w}/Mₙ = 2.1.

The preparation of P₉ (4, 5 - dioctyl benzo[2,1-b:3,4-b']dithiophene - 2, 3 - bis (2 - (9, 9 - dialkyl fluorene) yl) thieno [3,4-b] pyrazine conjugated polymer:

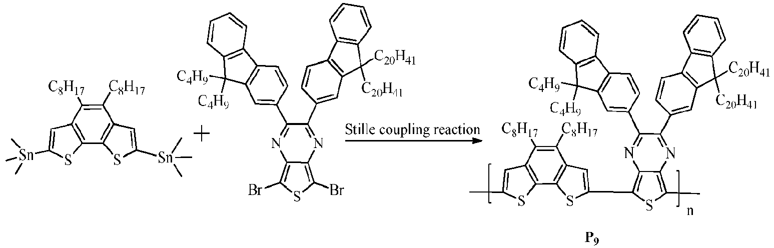

Under a nitrogen atmosphere, the toluene solution (30mL) containing 5, 7 - dibromo - 2 - (2 - (9, 9 - dioctyl fluorene) yl) thieno [3,4-b] pyrazine (0.65g, 0.5mmol) and 2, 7 - bistrimethyltin - 4, 5 - dioctyl benzo[2,1-b:3,4-b']dithiophene (0.37g, 0.5mmol) was bubbled for 0.5 hours to remove the residual oxygen. Pd₂(dba)₃ (0.014g, 0.015mol) and P(o-Tol)₃ (0.0083g, 0.027mmol) were added to the solution, and then the solution was bubbled for 1 hour to remove the residual oxygen. The solution was heated to 130°C and refluxed for 48 hours to obtain the conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 100°C and the conjugated polymer was separated by alumina column chromatography., after the conjugated polymer was rinsed by chlorobenzenem, the organic solvent was removed under reduced pressure. The obtained conjugated polymer was added to methanol, deposited, pumping filtrated, washed with methanol and dried, the conjugated polymer was extracted by acetone Soxhlet to obtain 0.41g conjugated polymer solid, the yield of the product was 53%. Molecular weight (GPC, THF, R. I): Mₙ = 11,300, M_{w}/Mₙ = 2.3.

Example 4

The 4, 5 - di - octyl benzo[2,1-b:3,4-b']dithiophene - 2, 3 - dialkyl thieno [3,4-b] pyrazine conjugated polymer is disclosed representing by the following formula:

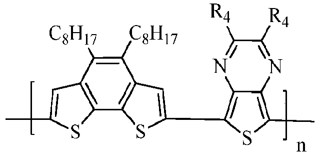

The preparation process of the polymer described above is as follows: firstly, the preparation of the compounds with the following formulas

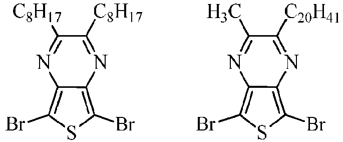

The preparation of 5, 7 - dibromo - 2, 3 - dioctyl thieno [3,4-b] pyrazine is taken as an example to illustrate, the preparation process is as follows:

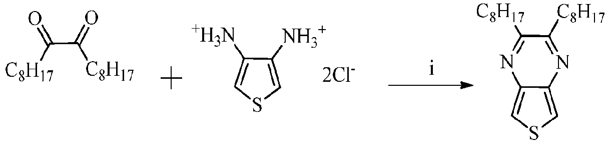

3, 4 - diamino - thiophene · HCl (1.0g, 5.34mmol) was added to the ethanol (50mL) solution which contained 1, 2 - dioctyl ethanedione compound (1.66g, 5.87mmol) and stirred overnight. After the reaction stopped, and the solvent was removed by rotary evaporation, 1.2g of solid was obtained through column chromatography, the yield of the product was 62%. MS (EI) m/z: 360 (M⁺).

Secondly, The preparation of 5, 7 - dibromo - 2, 3 - dioctyl thieno [3,4-b] pyrazine is taken as an example to illustrate, the preparation process is as follows: 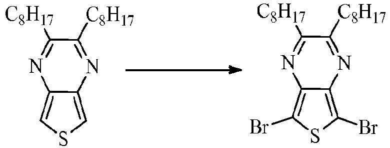 NBS (0.72g, 4mmol) was added to the chloroform/acetic acid (V/V = 1/1, 10mL) solution which contained 2, 3 - diphenyl - thieno [3,4-b] pyrazine compound (0.49g, 1.7mmol) and stirred overnight. The reaction solution was added to saturated sodium carbonate solution, extracted with chloroform, washed with water, and then dried over anhydrous sodium sulfate. After the solvent was removed by rotary evaporation, 0.42g of solid was obtained through column chromatography, the yield of the product was 55%. MS (EI) m/z: 446 (M⁺).

Thirdly, the preparation of conjugated polymer based on benzodithiophene and thienopyrazine

The preparation of P₁₀ (4, 5 - dioctyl benzo[2,1-b:3,4-b']dithiophene - 2, 3 - dialkyl thieno [3,4-b] pyrazine conjugated polymer:

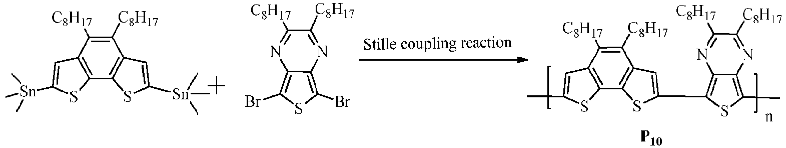

Under a nitrogen atmosphere, the toluene solution (30mL) containing 5, 7 - dibromo - 2, 3 - dioctyl - thieno [3,4-b] pyrazine (0.26g, 0.5mmol) and 2, 7 - bistrimethyltin - 4, 5 - dioctyl benzo[2,1-b:3,4-b']dithiophene (0.37g, 0.5mmol) was bubbled for 0.5 hours to remove the residual oxygen. Pd₂(dba)₃ (0.014g, 0.015mol) and P(o-Tol)₃ (0.0083g, 0.027mmol) were added to the solution, and then the solution was bubbled for 1 hour to remove the residual oxygen. The solution was heated to 80°C and refluxed for 72 hours to obtain the conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 80°C and the conjugated polymer was separated by alumina column chromatography, after the conjugated polymer was rinsed by chlorobenzenem, the organic solvent was removed under reduced pressure. The obtained conjugated polymer was added to methanol, deposited, pumping filtrated, washed with methanol and dried, the conjugated polymer was extracted by acetone Soxhlet to obtain 0.23g conjugated polymer solid, the yield of the product was 60%. Molecular weight (GPC, THF, R. I): Mₙ = 74,900, M_{w}/Mₙ = 1.9.

The preparation of P₁₁ (4,5 - dioctyl benzo[2,1-b:3,4-b']dithiophene - 2, 3 - dialkyl thieno [3,4-b] pyrazine conjugated polymer:

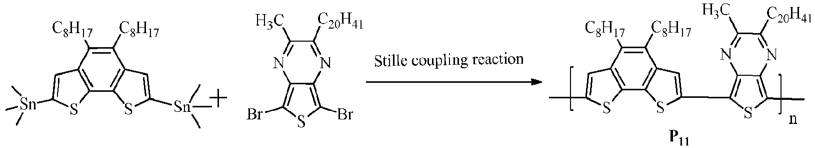

Under a nitrogen atmosphere, the toluene solution (30mL) containing 5, 7 - dibromo - 2 - methyl - 3 - n - eicosyl - thieno [3,4-b] pyrazine (0.29g, 0.5mmol) and 2, 7 - bistrimethyltin - 4, 5 - dioctyl benzo[2,1-b:3,4-b']dithiophene (0.37g, 0.5mmol) was bubbled for 0.5 hours to remove the residual oxygen. Pd₂(dba)₃ (0.014g, 0.015mol) and P(o-Tol)₃ (0.0083g, 0.027mmol) were added to the solution, and then the solution was bubbled for 1 hour to remove the residual oxygen. The solution was heated to 80°C and refluxed for 72 hours to obtain the conjugated polymer solution. The described conjugated polymer solution was added dropwise to methanol, deposited, pumping filtrated, dried, and a colloid containing conjugated polymer was obtained. The conjugated polymer colloid was dissolved to toluene, and the toluene solution was added to sodium diethyldithiocarbamate aqueous solution, heated and stirred at 80°C and the conjugated polymer was separated by alumina column chromatography, after the conjugated polymer was rinsed by chlorobenzenem, the organic solvent was removed under reduced pressure. The obtained conjugated polymer was added to methanol, deposited, pumping filtrated, washed with methanol and dried, the conjugated polymer was extracted by acetone Soxhlet to obtain 0.27g conjugated polymer solid, the yield of the product was 64%. Molecular weight (GPC, THF, R. I): Mₙ = 57,000, M_{w}/Mₙ = 2.1.

The following specific embodiments were the applications of the conjugated polymer based on benzodithiophene and thienopyrazine in the field of polymer solar cells, organic electroluminescent devices, organic field effect transistor, organic light storage, organic nonlinear material, organic laser material, and so on.

Example 5

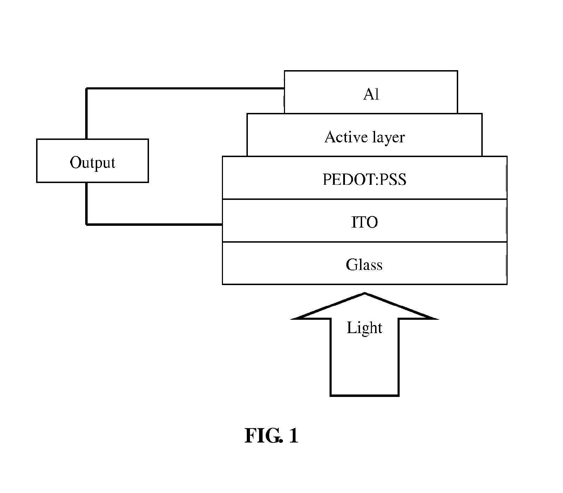

The structure of a kind of solar cell device was shown in FIG. 1. ITO glass (indium tin oxide glass) was used as substrate in the present embodiment, and ITO (indium tin oxide) was used as conductive layer.

The structure of the solar cell device was as follows: glass/ITO/PEDOT: PSS/active layer/Al; wherein the material of the active layer was mixture including [6,6] - phenyl - C61 - butyric acid methyl ester as electron donor materials and the conjugated polymer based on benzodithiophene and thienopyrazine as electron acceptor materials; ITO was indium tin oxide that the sheet resistance of the indium tin oxide was 10 to 20 Ω/□. PEDOT was poly 3, 4 - ethylenedioxy thiophene, PSS was polystyrene sulfonate.

The preparation process of the solar cell device was as follows:
the ITO glass was ultrasonic cleaned and treated with an oxygen-Plasma, and then the PEDOT: PSS layer was coated to the ITO surface for modification;
the active layer was coated on the described PEDOT: PSS layer by spin coating technology, the materials of active layer included [6,6] - phenyl - C61 - butyric acid methyl ester as electron donor materials and the conjugated polymer based on benzodithiophene and thienopyrazine as electron acceptor materials;
metal aluminum was evaporated onto the surface of the described active layer under vacuum condition, the metal aluminum layer was served as cathode, the described organic solar cell device was obtained. In this embodiment, the thickness of the metal aluminum layer was 170 nm. In other embodiments, the thickness of the metal aluminum layer might be 30 nm, 130 nm, 60 nm.

In this embodiment, the ITO conductive layer was served as anode, the solar cell device was kept 4 hours in 100 degrees Celsius under sealed conditions, and then cooled to room temperature, after the device annealed, the arranged order and tacticity within the groups and molecular chains of the molecule were effectively increased, the mobility and the rate of transmission speed of the carriers also increased, so that the photoelectric conversion efficiency of the solar cell device was improved.

Example 6

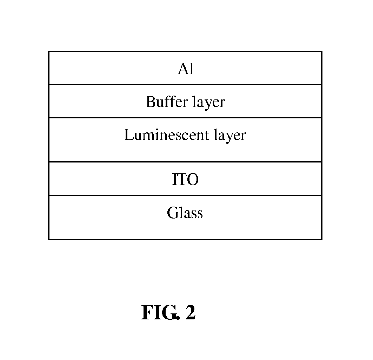

The structure of a kind of organic electroluminescent device was shown in FIG. 2. ITO glass (indium tin oxide glass) was used as substrate in the present embodiment, and ITO (indium tin oxide) was used as conductive layer.

The structure of the organic electroluminescent device was as follows: glass/ITO/luminescent layer/buffer layer/Al; wherein the material of the luminescent layer was conjugated polymer based on benzodithiophene and thienopyrazine; the material of the buffer layer was LiF; ITO was indium tin oxide that the sheet resistance of the indium tin oxide was 10-20 Ω/□, PEDOT was poly 3, 4 - ethylenedioxy thiophene, PSS was polystyrene sulfonate.

The preparation process of the organic electroluminescent device was as follows:
the ITO glass was ultrasonic cleaned and treated with an oxygen-Plasma, and then the conjugated polymer based on benzodithiophene and thienopyrazine was coated onto the ITO surface and formed as luminescent layer;
the LiF was evaporated onto the surface of the described luminescent layer under vacuum condition and formed as buffer layer;
metal aluminum was evaporated onto the surface of the described buffer layer under vacuum condition. The metal aluminum layer was served as cathode, the organic electroluminescent device was obtained. In this embodiment, the thickness of the metal aluminum layer was 170 nm, in other embodiments, the thickness of the metal aluminum layer might be 30 nm, 130 nm, 60 nm. In this embodiment, the ITO conductive layer was served as an anode.

Example 7

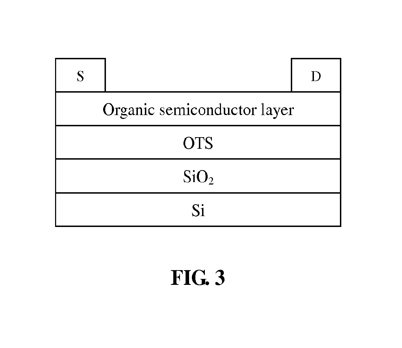

The structure of a kind of organic field-effect transistor was shown in FIG. 3. Highly doped silicon wafer was used as substrate in the present embodiment.

The structure of the organic field-effect transistor was as follows: Si/SiO₂/OTS/organic semiconductor layer/source electrode (S) and drain electrode (D). Wherein, the thickness of the SiO₂ with function of insulation was 450nm; OTS was octadecyltrichlorosilane; the material of the organic semiconductor layer was the conjugated polymer based on benzodithiophene and thienopyrazine; the source electrode (S) and drain electrode (D) were made of gold, in other embodiments, the source electrode (S) and drain electrode (D) can be made of copper.

The preparation process of the organic field-effect transistor was as follows: the doped silicon wafer substrate was cleaned, the SiO₂ layer with the function of insulation was deposited on the surface of the substrate;
the OTS was coated on the surface of the SiO₂ insulation layer and formed as OTS layer;
the conjugated polymer based on benzodithiophene and thienopyrazine was coated onto the surface of the OTS layer and formed as organic semiconductor layer;
the gold source electrode and the gold drain electrode were disposed on the organic semiconductor layer, the organic field-effect transistor was obtained.

It should be understood that the embodiments described above only expressed several implement patterns, and the descriptions are specific and detailed, but those descriptions can't be used to limit the present disclosure. It should be noted that for those of ordinary skill in the art, under the premise of without departing from the inventive concept, may be made a number of deformation and improved, which all belong to the scope of protection of the present invention. Therefore, the scope of protection of the invention patent should be subject to the appended claims.

## Claims

1. A conjugated polymer based on benzodithiophene and thienopyrazine, represented by the following formula: 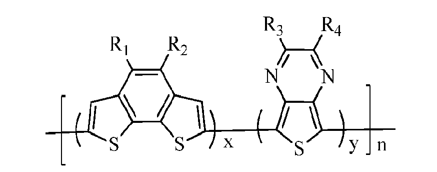 wherein x+y=2, 0<y≤1, n represents an integer between 1 and 100;
R₁, R₂ represent C₁ to C₂₀ alkyl;
R₃, R₄ represent H, C₁ to C₂₀ alkyl, C₁ to C₂₀ alkoxy or C₁ to C₂₀ aryl.

2. The conjugated polymer according to claim 1, wherein the C₁ to C₂₀ aryl is selected from the group consisting of: 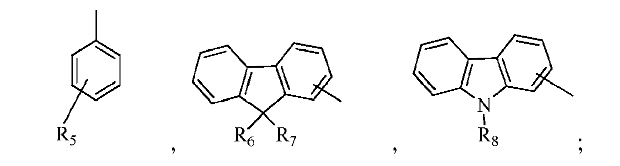 wherein R₅ represents C₁ to C₁₅ alkyl or C₁ to C₁₅ alkoxy, R₆, R₇, R₈ represent C₁ to C₁₅ alkyl.

3. A preparation method of the conjugated polymer based on benzodithiophene and thienopyrazine, comprising the following steps:
S11, providing compounds A, B and C represented by the following formulas, respectively, 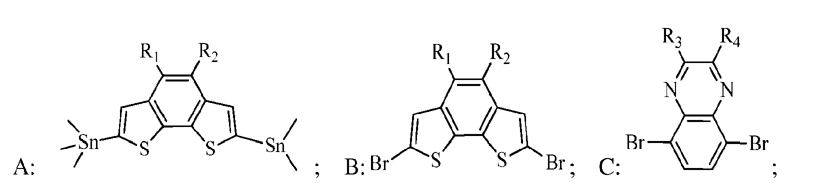
S 12, mixing compounds A, B and C, and subjecting compounds A, B and C to a Stille coupling reaction in the presence of catalyst and organic solvent under conditions of anhydrous and oxygen-free environment; 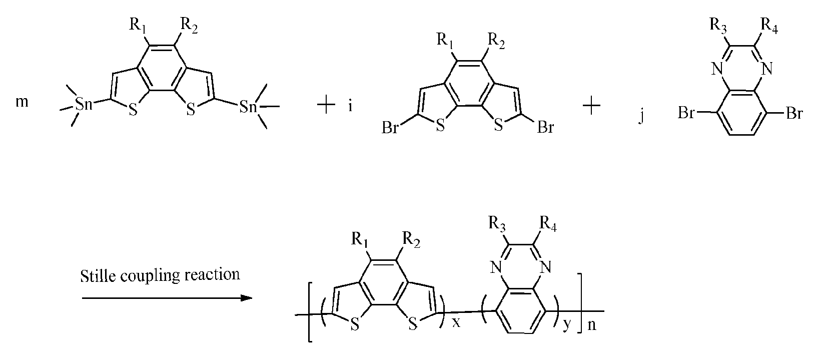
wherein m=i+j, 0≤i<m; and the conjugated polymer represented by the following formula is obtained: 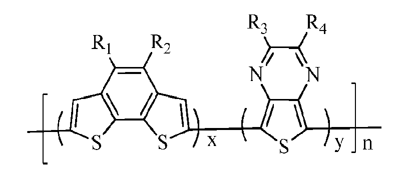
wherein x+y=2, 0<y≤1, n represents an integer between 1 and 100;
R₁, R₂ represent C₁ to C₂₀ alkyl;
R₃, R₄ represent H, C₁ to C₂₀ alkyl, C₁ to C₂₀ alkoxy or C₁ to C₂₀ aryl.

4. The preparation method according to claim 3, wherein the C₁ to C₂₀ aryl is selected from the group consisting of: 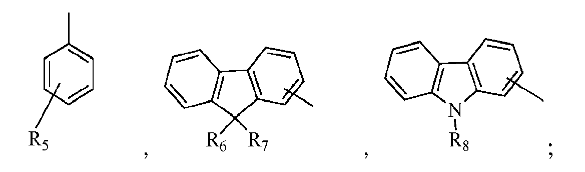 wherein R₅ represents C₁ to C₁₅ alkyl or C₁ to C₁₅ alkoxy, R₆, R₇, R₈ represent C₁ to C₁₅ alkyl.

5. The preparation method according to claim 3, wherein in step S11, the compound C is prepared by the following steps:
providing compounds D and E represented by the following formulas, respectively, 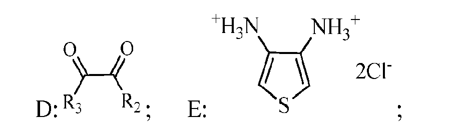
mixing and dissolving compounds D and E to solvent according according to a molar ratio of 1:0.1 to 1:10 at a temperature of 0 to 78 , and adding weak base according to a molar ratio of the weak base to the compound D of 2 to 50 times, reacting for 1 to 24 hours to obtain compound F represented by the following formula: 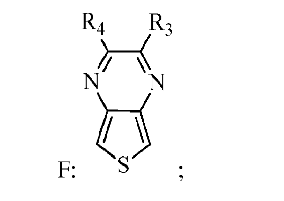
wherein the solvent is at least one selected from methanol, ethanol and ethyl acetate, and the weak base is selected from triethylamine and sodium carbonate;
adding compound F to a mixture solution of chloroform and acetic acid at a temperature of 0 to 70□, and then adding n-bromosuccinimide, reacting for 1 to 48 hours to obtain compound C represented by the following formula:

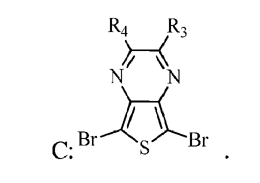

6. The preparation method according to claim 3, wherein in step S12, the organic solvent is at least one selected from the group consisting of tetrahydrofuran, ethylene glycol, dimethyl ether, benzene, chlorobenzene and toluene;
the reaction temperature is 60 to 130 , and the reaction time is 24 to 72 hours;
the added amount of the catalyst is 0.05% to 50% of a molar amount of compound A;
the catalyst is organic palladium catalyst or a mixture of organic palladium and organic phosphine ligand;
the organic palladium is Pd₂(dba)₃ Pd(PPh₃)₄ or Pd(PPh₃)₂Cl₂;
the organic phosphine ligand is P(o-Tol)₃;
a molar ratio of the organic palladium to the organic phosphine ligand is 1:2 to 1:20 in the mixture of organic palladium and organic phosphine ligand.

7. The preparation method according to claim 3, further comprising: purifying the obtained conjugated polymer, wherein the purification steps comprise:
S13, adding the conjugated polymer to methanol dropwise, depositing, pumping filtrating, washing with methanol, and drying to obtain a colloid containing conjugated polymer colloid;
S14, dissolving the colloid containing conjugated polymer into toluene, and then adding the toluene solution to the aqueous solution of sodium diethyl dithiocarbamate, stirring and heating to 80 to 100⊐, purifing by alumina column chromatograph to separate conjugated polymer, washing with chlorobenzene and removing the organic solvent under reduced pressure;
S15, repeating step S13 at least once, extracting the conjugated polymer separated from step S14 by acetone Soxhlet to obtain conjugated polymer solid.

8. A solar cell device made from the conjugated polymer according to claim 1, comprising a substrate, a conductive layer deposited on one surface of the substrate serving as an anode, a poly 3, 4 - ethylenedioxy thiophene: polystyrene sulfonate layer coated on the conductive layer functioned for modification, an active layer coated on the poly 3, 4 - ethylenedioxy thiophene: polystyrene sulfonate layer, and an aluminum layer disposed on the active layer serving as a cathode; the material of the active layer being mixture which comprises electron donor material and electron acceptor material; the electron acceptor material is [6,6]-phenyl-C61-butyric acid methyl ester, wherein the electron donor material comprises conjugated polymer based on benzodithiophene and thienopyrazine according to claim 1.

9. A organic electroluminescent device made from the conjugated polymer according to claim 1, comprising a substrate, a conductive layer deposited on one surface of the substrate serving as an anode, a luminescent layer coated on the conductive layer, a buffer layer with the material of LiF evaporated on the luminescent layer under vacuum condition, and an aluminum layer disposed on the buffer layer serving as a cathode; wherein the luminescent layer comprises the conjugated polymer based on benzodithiophene and thienopyrazine according to claim 1.

10. A organic field-effect transistor made from the conjugated polymer according to claim 1, comprising a doped silicon wafer, a SiO₂ insulation layer, an octadecyltrichlorosilane layer functioned for modifying the SiO₂ insulation layer, an organic semiconductor layer coated on the octadecyltrichlorosilane layer, a source electrode and a drain electrode interval disposed on the organic semiconductor layer, which are laminated in this order, wherein the organic semiconductor layer comprises the conjugated polymer based on benzodithiophene and thienopyrazine according to claim 1.
